# EUROPEAN PATENT APPLICATION

(11) **EP 4 254 688 A1**
(43) Date of publication of application: **04.10.2023**
(21) Application number: 21897469.9
(22) Date of filing: 17.09.2021
(51) Int. Cl.: H01S 5/022, H01S 5/0236, H01S 5/024

(54) **LASER MODULE**

(30) Priority: 26.11.2020 JP 2020195659
(71) Applicant: Panasonic Intellectual Property Management Co., Ltd., Osaka-shi, Osaka 540-6207 (JP)
(72) Inventor: OOMORI, Kouji, Osaka 540-6207 (JP)
(74) Representative: Novagraaf International SA
(86) International application number: PCT/JP2021/034323
(87) International publication number: WO 2022/113491

(57) **Abstract**

First block (10) and second block (20) are placed on top of each other with insulation sheet (45) interposed therebetween. First adherend surface (12) and second adherend surface (22) are provided on a facing surface of first block (10) and a facing surface of second block (20), respectively. Adhesive (50) is applied to first adherend surface (12) and second adherend surface (22). First block (10) and second block (20) are bonded to each other with adhesive (50).

## Description

### TECHNICAL FIELD

The present disclosure relates to a laser module.

### BACKGROUND ART

PTL 1 discloses a semiconductor laser device that uses a fixing screw to fix a lower electrode block on which semiconductor laser elements are disposed, and an upper electrode block that is provided in a manner covering the semiconductor laser elements from the above.

### Citation List

### Patent Literature

PTL 1: WO 2019/225128 A

### SUMMARY OF THE INVENTION

### Technical problem

In the conventional invention, when a fixing screw becomes loose, the upper electrode block may become separated from the semiconductor laser elements, and lose the electrical contact with the semiconductor laser elements.

Therefore, the inventor of the invention that is the subject of the present application has considered fixing the two blocks with an adhesive by applying the adhesive along a periphery of an area where the upper electrode block and the lower electrode block are stacked facing each other. However, if the adhesive is applied only to the periphery of the two blocks, it is not possible to achieve a sufficient area for bonding. Therefore, the inventor has considered that it would be desirable if the area by which the two blocks are bonded can be increased.

The present disclosure has been made in consideration of this point, and an object of the present disclosure is to ensure a sufficient area for bonding between two blocks, so that the blocks can be fixed to each other stably.

### Solutions to problem

According to a first aspect of the present invention, a laser module including a laser element that emits a laser beam, the laser module including: a first block that is electrically connected to a positive electrode of the laser element; an insulation sheet that is placed on the first block; and a second block that is placed above the first block with the insulation sheet interposed between the first block and the second block, the second block being electrically connected to a negative electrode of the laser element, wherein the first block includes a facing surface facing the second block serving as a first adherend surface, and the second block includes a facing surface facing the first block serving as a second adherend surface, and the first block and the second block are bonded with an adhesive applied to the first adherend surface and the second adherend surface.

In the first aspect of the present invention, the first block and the second block are placed on top of each other with the insulation sheet interposed between the first block and the second block. The first adherend surface and the second adherend surface are provided to the facing surface of the first block facing the second block and the facing surface of the second block facing the first block, respectively. The adhesive is then applied to the first adherend surface and the second adherend surface. The first block and the second block are thus bonded with the adhesive.

Because the first adherend surface and the second adherend surface are provided to the facing surface of the first block and the facing surface of the second block, respectively, and the first adherend surface and the second adherend surface are bonded with the adhesive in the manner described above, it is possible to fix the first block and the second block stably while ensuring a sufficient bonding area.

According to a second aspect of the present invention, the insulation sheet according to the first aspect includes an opening hole penetrating in a thickness direction, and the adhesive is applied to an application space surrounded by the first adherend surface of the first block, the second adherend surface of the second block, and a periphery of the opening hole of the insulation sheet.

According to the second aspect of the present invention, the insulation sheet includes the opening hole. The application space is surrounded by the first adherend surface of the first block, the second adherend surface of the second block, and the periphery of opening hole of the insulation sheet. The adhesive is applied to the application space.

With this, because the adhesive applied into the application space spreads inside of the opening hole, it is possible to increase the area for bonding. In addition, because the adhesive spreading inside the opening hole stops at the periphery of the opening hole of the insulation sheet, it is possible to suppress leakage from the application space.

According to a third aspect of the present invention, the insulation sheet according to the second aspect includes a continuous passage connected to inside and outside of the application space.

According to the third aspect of the present invention, the insulation sheet includes the continuous passage. The continuous passage is connected to the inside and the outside of the application space. The continuous passage is formed by cutting out a part of the insulation sheet, for example.

With this, by allowing the air pushed out by the adhesive being applied into the application space to be released through the continuous passage provided to the insulation sheet, the adhesive is allowed to spread smoothly.

According to a fourth aspect of the present invention, at least one of the first block and the second block according to the second aspect of the present invention includes a vent connected to the inside and the outside of the application space.

According to the fourth aspect of the present invention, at least one of the first block and the second block includes the vent. The vent is connected to the inside and the outside of the application space.

With this, by allowing the air pushed out by the adhesive being applied into the application space to be released through the continuous passage provided to the insulation sheet, the adhesive is allowed to spread smoothly.

According to a fifth aspect of the present invention, at least one of the first adherend surface and the second adherend surface according to any one of the first to fourth aspects of the present invention includes a recess.

In the fifth aspect of the present invention, the recess is provided on at least one of the first adherend surface and the second adherend surface. The adhesive is then applied in the recess.

As a result, because the adhesive applied into the recess spreads inside the recess, it is possible to increase the area for bonding. In addition, because the adhesive spreading inside the recess stops at the peripheral wall of the recess, it is possible to suppress leakage from the application space.

According to a sixth aspect of the present invention, at least one of the first block and the second block according to any one of the second to the fourth aspect includes an vent hole that is connected to the application space.

According to the sixth aspect of the present invention, at least one of the first block and the second block includes the vent hole. The vent hole is connected to the application space.

With such a configuration, it is possible to inject the adhesive via the vent hole in a configuration in which the first block and the second block are placed on top of each other. In this manner, it is possible to suppress leakage of the adhesive from the gap formed between the first block and the second block.

According to a seventh aspect of the present invention, the adhesive according to any one of the first to the sixth aspect of the present invention has higher thermal conductivity than the insulation sheet.

According to the seventh aspect of the present invention, by making the thermal conductivity of the adhesive higher than that of the insulation sheet, the adhesive can dissipate the heat generated in the laser element.

The insulation sheet is made of polyimide, for example. The adhesive is made of an epoxy resin, for example. The epoxy resin preferably contains filler by 50 weight percent to 95 weight percent. The filler is made of aluminum nitride, for example. Advantageous effect of invention

According to the present disclosure, it is possible to ensure a sufficient area for bonding between two blocks, and to fix the blocks to each other stably.

### BRIEF DESCRIPTION OF THE DRAWINGS

Fig. 1 is a perspective view illustrating a configuration of a laser module according to a first exemplary embodiment.
Fig. 2 is an exploded perspective view illustrating the configuration of the laser module.
Fig. 3 is a sectional side view illustrating the configuration of the laser module.
Fig. 4 is a perspective view illustrating a configuration of a laser module according to a second exemplary embodiment.
Fig. 5 is an exploded perspective view illustrating the configuration of the laser module.
Fig. 6 is a sectional side view illustrating the configuration of the laser module.
Fig. 7 is a perspective view illustrating a configuration of a laser module according to a third exemplary embodiment.
Fig. 8 is an exploded perspective view illustrating the configuration of the laser module.
Fig. 9 is a perspective view illustrating the configuration of a second adherend surface of a second block.
Fig. 10 is a sectional side view illustrating the configuration of the laser module.

### DESCRIPTION OF EMBODIMENT

Some exemplary embodiments of the present disclosure will now be explained with reference to the drawings. The following description of the preferable exemplary embodiments is merely illustrative in nature, and is not intended to limit the present disclosure, its application, or its use.

### <<First exemplary embodiment>>

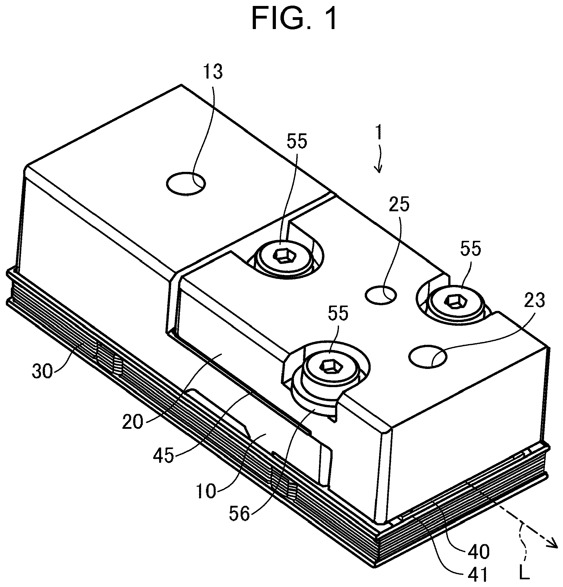

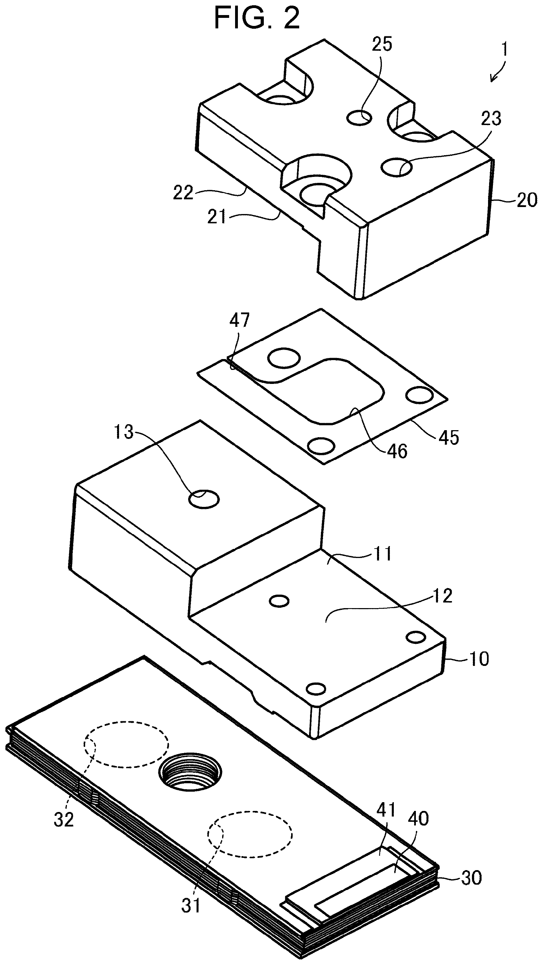

As illustrated in Figs. 1 and 2, laser module 1 includes first block 10, cooling block 30, second block 20, laser element 40, and insulation sheet 45.

First block 10 has conductivity. First block 10 is mainly made of copper (Cu). First block 10 is a copper block plated with nickel (Ni) and gold (Au), sequentially.

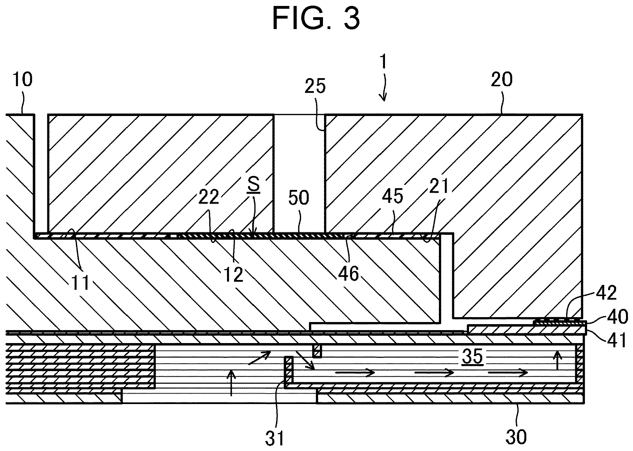

First block 10 has first step portion 11. First step portion 11 has a step-like shape formed by providing a cutout on an upper surface, on an outgoing side of laser beam L (in the direction indicated by the arrow in Fig. 1). First adherend surface 12 is provided on the upper surface of first step portion 11. Adhesive 50, to be described later, is applied to first adherend surface 12 (see Fig. 3).

First block 10 has first terminal hole 13. First terminal hole 13 is provided on the upper surface of first block 10, on an opposite side of the outgoing side of the laser beam. To first terminal hole 13, a positive electrode of a power supply, not illustrated, is connected.

Insulation sheet 45 is placed on the upper surface of first step portion 11 of first block 10. Insulation sheet 45 is made of polyimide, for example. Insulation sheet 45 has opening hole 46 penetrating in the thickness direction. Opening hole 46 opens in a central portion of insulation sheet 45. Insulation sheet 45 is provided with continuous passage 47. Continuous passage 47 is formed by cutting out a part of the periphery of insulation sheet 45.

Second block 20 is placed above first block 10 with insulation sheet 45 interposed therebetween. Second block 20 has conductivity. Second block 20 is mainly made of copper (Cu). Second block 20 is a copper block plated with nickel (Ni) and gold (Au), sequentially.

Second block 20 has second step portion 21. Second step portion 21 has a step-like shape formed by providing a cutout out on a lower surface, on the opposite side of the outgoing side of laser beam L. Second adherend surface 22 is provided on the lower surface of second step portion 21. Adhesive 50, to be described later, is applied to second adherend surface 22 (see Fig. 3).

Second block 20 has second terminal hole 23. Second terminal hole 23 is provided on the upper surface of second block 20, on the outgoing side of the laser beam. To second terminal hole 23, a negative electrode of the power supply, not illustrated, is connected.

Cooling block 30 is placed under the lower surface of first block 10. Cooling block 30 is mainly made of copper (Cu). Cooling block 30 is formed in a block-like shape by stacking a plurality of plate members. As will be described later in detail, internal passage 35 through which a cooling medium is passed is provided inside cooling block 30 (see Fig. 3).

An end part of cooling block 30 on the outgoing side of laser beam L extends further frontwards toward the direction in which the laser beam L is emitted, being further than second block 20. Submount 41 is placed on the upper surface of the end part of cooling block 30.

Submount 41 has conductivity. Submount 41 is mainly made of a copper-tungsten alloy (CuW). Laser element 40 is placed on submount 41. Laser element 40 has a lower surface serving as a positive electrode, and an upper surface serving as a negative electrode.

First block 10 and second block 20 are fixed to each other with screws 55. Insulating bush 56 is interposed between second block 20 and each screw 55. Second block 20 is electrically insulated from first block 10 and cooling block 30. First block 10 and second block 20 are bonded to each other with adhesive 50 (see Fig. 3). First block 10 and cooling block 30 are fixed to each other with screws, not illustrated.

As also illustrated in Fig. 3, first block 10 is electrically connected to the lower surface of laser element 40 via cooling block 30 and submount 41. First block 10 has a function as an electrode block electrically connecting to the positive electrode of laser element 40.

Second block 20 is electrically connected to the upper surface of laser element 40 via bump 42. Second block 20 has a function as an electrode block electrically connecting to the negative electrode of laser element 40.

### <Bonding structure>

A configuration for bonding first block 10 and second block 20 with adhesive 50 will now be explained.

As illustrated in Fig. 3, first adherend surface 12 and second adherend surface 22 are exposed to opening hole 46 of insulation sheet 45 in a configuration in which first block 10, insulation sheet 45, and second block 20 are placed on top of one another.

Application space S for applying adhesive 50 is formed inside laser module 1. Application space S includes a space surrounded by first adherend surface 12 of first block 10, second adherend surface 22 of second block 20, and the periphery of opening hole 46 of insulation sheet 45.

Insulation sheet 45 is provided with continuous passage 47 (see Fig. 2). Continuous passage 47 is connected to the inside and the outside of application space S. Second block 20 is provided with vent hole 25. Vent hole 25 is connected to application space S.

Adhesive 50 injected from vent hole 25 of second block 20 is applied into application space S. Because adhesive 50 applied into application space S spreads inside application space S, it is possible to increase the area for bonding.

In addition, adhesive 50 spreading inside application space S stops at the periphery of opening hole 46 of insulation sheet 45. As a result, it is possible to suppress leakage of adhesive 50 from application space S.

Furthermore, by releasing the air pushed out by adhesive 50 being applied to application space S, via continuous passage 47 of insulation sheet 45, adhesive 50 is allowed to spread smoothly.

When adhesive 50 having spread inside application space S become cured, first adherend surface 12 of first block 10 and second adherend surface 22 of second block 20 come to be bonded.

In this example, adhesive 50 is made of an epoxy resin, for example. The epoxy resin preferably contains filler by 50 weight percent to 95 weight percent. The filler is made of aluminum nitride, for example.

Adhesive 50 made of an epoxy resin has higher thermal conductivity than insulation sheet 45 made of polyimide. In this manner, adhesive 50 can dissipate the heat generated by laser element 40.

### <Internal passage>

When a current flows from the positive electrode toward the negative electrode of laser element 40, laser module 1 is caused to emit laser beam L from the light emitting surface that is a side surface of laser element 40. At this time, the heat generated by laser element 40 is transferred to first block 10, second block 20, and cooling block 30.

As illustrated in Fig. 3, cooling block 30 is provided with internal passage 35. Cooling block 30 is formed by laminating a plurality of plate members. Each of the plate members has a hole (not illustrated) configuring a part of internal passage 35. By laminating the plate members and connecting the holes, internal passage 35 is integrally formed.

Cooling block 30 has supply hole 31 and discharge hole 32. Supply hole 31 and discharge hole 32 are connected to internal passage 35. A chiller unit, not illustrated, supplies a cooling medium from the outside into supply hole 31. The cooling medium is water, for example. The cooling medium is supplied into internal passage 35 from supply hole 31. The arrow in Fig. 3 indicates the flow of the cooling medium.

The cooling medium supplied into internal passage 35 from supply hole 31 flows to a position below laser element 40, and then flows through a passage (not illustrated) toward discharge hole 32.

The cooling medium is discharged from internal passage 35 to the outside via discharge hole 32, and returned to the chiller unit, not illustrated.

As described above, with laser module 1 according to the present exemplary embodiment, first adherend surface 12 and second adherend surface 22 are provided on the facing surface of first block 10 and the facing surface of second block 20, respectively, and first adherend surface 12 and second adherend surface 22 are bonded with adhesive 50. As a result, first block 10 and second block 20 can be fixed stably by ensuring a sufficient area for bonding.

### <<Second exemplary embodiment>>

In the explanation below, the same reference marks will be given to the parts that are the same as those in the first exemplary embodiment, and only differences will be explained.

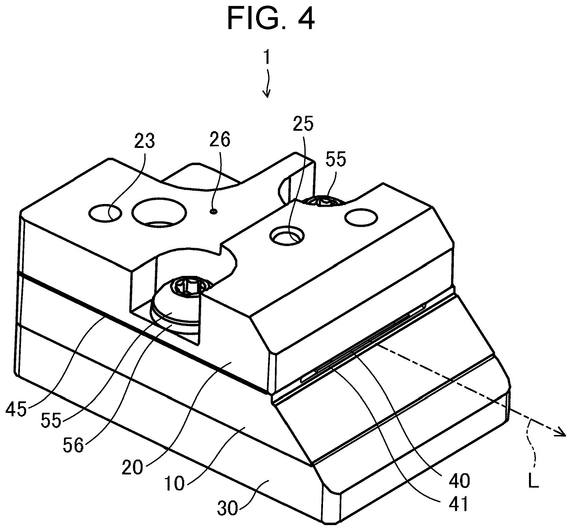

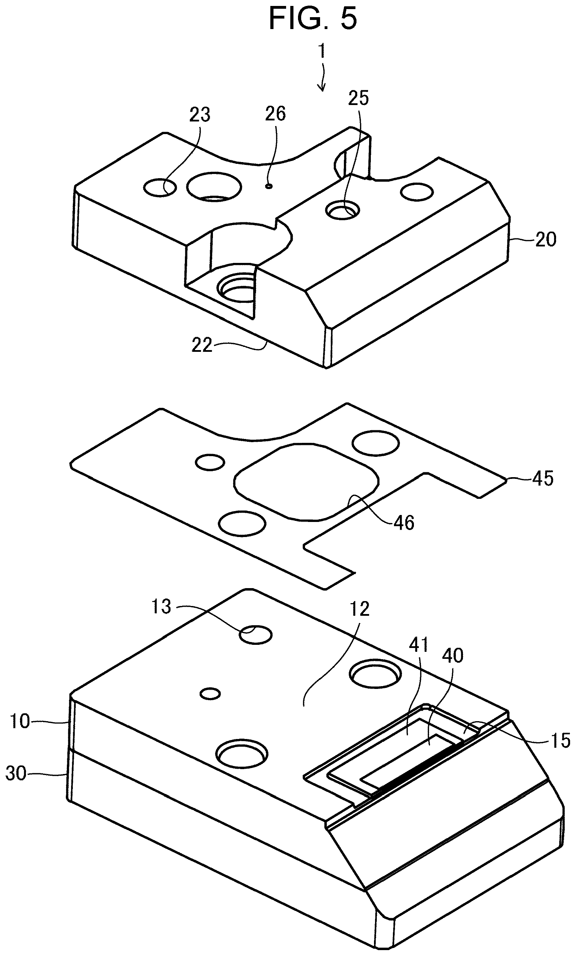

As illustrated in Figs. 4 and 5, first block 10 has conductivity. First adherend surface 12 is provided on the upper surface of first block 10. First block 10 includes mount surface 15. mount surface 15 is provided as a recess formed on a part of the upper surface of first block 10. Mount surface 15 is provided on an end part of the upper surface of first block 10, the end part being an end on the outgoing side of laser beam L (the direction indicated by the arrow in Fig. 4).

Submount 41 is placed on mount surface 15. Laser element 40 is placed on submount 41. Laser element 40 has a lower surface serving as a positive electrode, and an upper surface serving as a negative electrode.

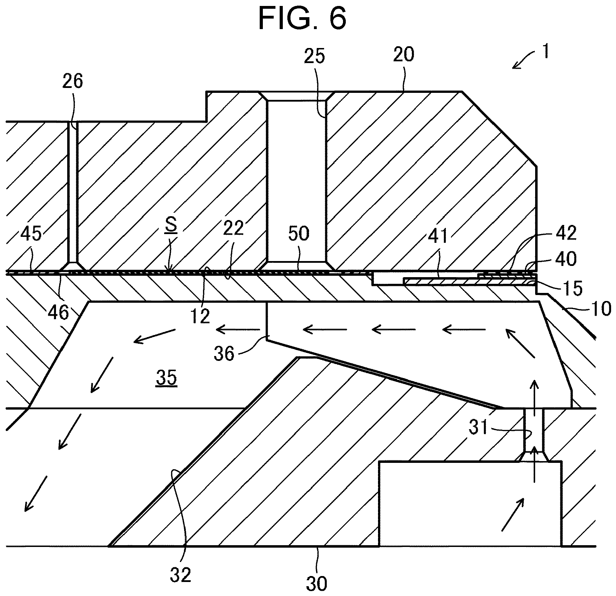

The positive electrode of laser element 40 is electrically connected to first block 10 via submount 41. The negative electrode of laser element 40 is electrically connected to second block 20 via bump 42 (see Fig. 6).

Insulation sheet 45 is provided on the upper surface of first block 10. Insulation sheet 45 is provided with opening hole 46. Second block 20 is placed above first block 10 with insulation sheet 45 interposed therebetween.

Second block 20 has conductivity. Second adherend surface 22 is provided on the lower surface of second block 20.

Cooling block 30 is placed on a side facing opposite side of mount surface 15 of the first block 10. Cooling block 30 is mainly made of stainless steel (SUS). Cooling block 30 is a stainless steel block plated with nickel (Ni) and gold (Au), sequentially.

As will be described in detail later, internal passage 35 through which a cooling medium is passed is provided between first block 10 and cooling block 30 (see Fig. 6).

First block 10, second block 20, and cooling block 30 are fixed with screws 55. Insulating bush 56 is interposed between second block 20 and each screw 55. Second block 20 is electrically insulated from first block 10 and cooling block 30. First block 10 and second block 20 are bonded to each other with adhesive 50 (see Fig. 6).

### <Bonding structure>

As illustrated in Fig. 6, application space S for applying adhesive 50 is formed inside laser module 1. Application space S includes a space surrounded by first adherend surface 12 of first block 10, second adherend surface 22 of second block 20, and the periphery of opening hole 46 of insulation sheet 45.

Second block 20 is provided with vent hole 25 and vent 26. Vent hole 25 is connected to application space S. Vent 26 is connected to application space S. Note that vent 26 may be provided in first block 10.

Adhesive 50 injected from vent hole 25 of second block 20 is applied into application space S. Because adhesive 50 applied into application space S spreads inside application space S, it is possible to increase the area for bonding.

In addition, adhesive 50 spreading inside application space S stops at the periphery of opening hole 46 of insulation sheet 45. As a result, it is possible to suppress leakage of adhesive 50 from application space S.

Furthermore, by releasing the air pushed out by adhesive 50 being applied to application space S from vent 26, adhesive 50 is allowed to spread smoothly.

When adhesive 50 having spread inside application space S become cured, first adherend surface 12 of first block 10 and second adherend surface 22 of second block 20 come to be bonded.

### <Internal passage>

As illustrated in Fig. 6, first block 10 is provided with internal passage 35. Internal passage 35 is provided as a recess formed on a part of the lower surface of first block 10. Internal passage 35 extends rearwards (leftwards in Fig. 6) from the surface on the opposite side of mount surface 15.

First block 10 is provided with a plurality of fins 36. Fins 36 erect from the surface on the opposite side of mount surface 15 of first block 10. Each fin 36 is formed as a plate-like shape, and extends in the direction in which laser beam L is emitted. Fins 36 are disposed in internal passage 35, in a manner spaced from one another in a thickness direction.

In this manner, by providing fins 36 in first block 10, the heat dissipation area of first block 10 is increased.

Cooling block 30 is placed on the side facing opposite side of mount surface 15 of first block 10. Internal passage 35 is provided between first block 10 and cooling block 30.

Cooling block 30 has a plurality of supply holes 31 and discharge hole 32. Supply hole 31 and discharge hole 32 are connected to internal passage 35. A chiller unit, not illustrated, supplies a cooling medium from the outside into supply hole 31. The cooling medium is water, for example. The cooling medium is supplied into internal passage 35 from supply hole 31. The arrows in Fig. 6 indicate the flow of the cooling medium.

The cooling medium supplied from the plurality of supply holes 31 to internal passage 35 is supplied between fins 36, and flows downstream along the upper surface of internal passage 35.

Discharge hole 32 has an opening on a downstream side of internal passage 35 in cooling block 30. The cooling medium is discharged from internal passage 35 to the outside via discharge hole 32, and returned to the chiller unit, not illustrated.

### <<Third exemplary embodiment>>

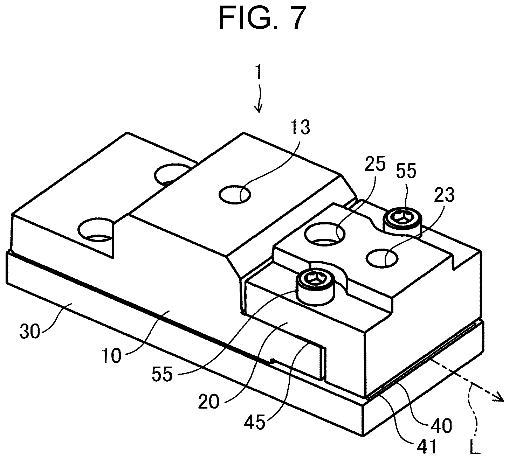

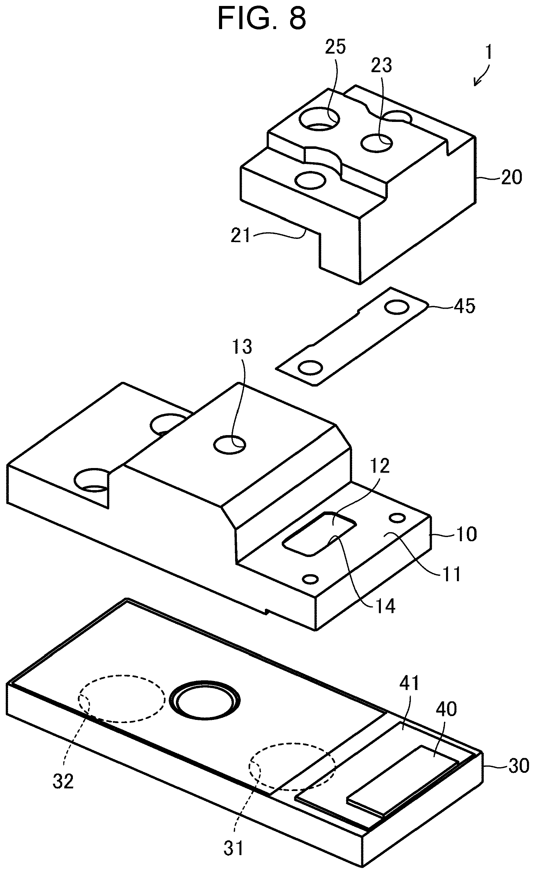

As illustrated in Figs. 7 and 8, first block 10 has first step portion 11. First step portion 11 has a step-like shape formed by providing a cutout on an upper surface on the outgoing side of laser beam L (in the direction indicated by the arrow in Fig. 7). First recess 14 is provided on the upper surface of first step portion 11. First recess 14 is formed as a recess formed on a part of the upper surface of first block 10. First adherend surface 12 is provided on the bottom of first recess 14.

Insulation sheet 45 is placed on the upper surface of first step portion 11 of first block 10. Second block 20 is placed above first block 10 with insulation sheet 45 interposed therebetween.

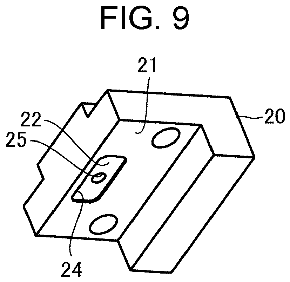

As also illustrated in Fig. 9, second block 20 has second step portion 21. Second step portion 21 has a step-like shape formed by providing a cutout out on a lower surface, on the opposite side of the outgoing side of laser beam L. Second recess 24 is provided on the lower surface of second step portion 21. Second recess 24 is provided as a recess formed on a part of the lower surface of second block 20. Second adherend surface 22 is provided on the bottom surface of second recess 24.

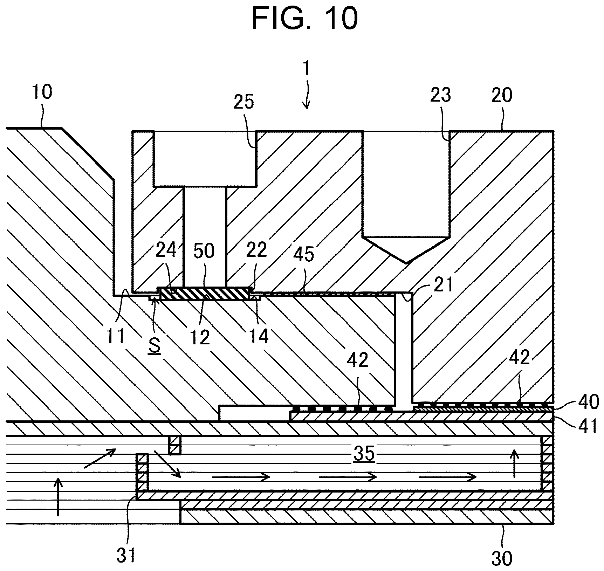

Cooling block 30 is placed under the lower surface of first block 10. Cooling block 30 is mainly made of copper (Cu). Cooling block 30 is formed in a block-like shape by stacking a plurality of plate members. Internal passage 35 through which a cooling medium flows is provided inside cooling block 30 (see Fig. 10).

Submount 41 is placed on the upper surface of the end part of cooling block 30. Laser element 40 is placed on submount 41. Laser element 40 has a lower surface serving as a positive electrode, and an upper surface serving as a negative electrode.

First block 10 and second block 20 are fixed to each other with screws 55. Insulation sheet 45 is interposed between first block 10 and second block 20. Second block 20 is electrically insulated from first block 10. First block 10 and second block 20 are bonded to each other with adhesive 50 (see Fig. 10). First block 10 and cooling block 30 are fixed to each other with screws, not illustrated.

As also illustrated in Fig. 10, first block 10 is electrically connected to the lower surface of laser element 40 via bump 42 and submount 41. Second block 20 is electrically connected to the upper surface of laser element 40 via bump 42.

### <Bonding structure>

A configuration for bonding first block 10 and second block 20 with adhesive 50 will now be explained.

As illustrated in Fig. 10, in a configuration in which first block 10, insulation sheet 45, and second block 20 are placed on top of one another, first adherend surface 12 of first recess 14 and second adherend surface 22 of second recess 24 are disposed in a manner facing each other.

Application space S for applying adhesive 50 is formed inside laser module 1. Application space S is formed as a space surrounded by the peripheral wall of first recess 14 and first adherend surface 12 of first block 10, the peripheral wall of second recess 24 and second adherend surface 22 of second block 20, and the periphery of insulation sheet 45.

Second block 20 is provided with vent hole 25. Vent hole 25 is connected to application space S.

Adhesive 50 injected from vent hole 25 of second block 20 is applied into application space S. Because adhesive 50 applied into application space S spreads inside application space S, it is possible to increase the area for bonding.

In addition, adhesive 50 spreading inside application space S stops at the peripheral walls of first recess 14 and second recess 24. As a result, it is possible to suppress leakage of adhesive 50 from application space S.

When adhesive 50 having spread inside application space S become cured, first adherend surface 12 of first block 10 and second adherend surface 22 of second block 20 come to be bonded.

Note that, because internal passage 35 of cooling block 30 has the same configuration as that of the first exemplary embodiment, an explanation is omitted herein.

### INDUSTRIAL APPLICABILITY

As described above, the present disclosure is extremely useful and has high industrial applicability, because it is possible to achieve a highly useful effect that two blocks can be fixed to each other stably by ensuring sufficient areas for bonding, on the respective blocks.

### REFERENCE MARKS IN THE DRAWINGS

- 1: laser module
- 10: first block
- 12: first adherend surface
- 14: first recess
- 20: second block
- 22: second adherend surface
- 24: second recess
- 25: vent hole
- 26: vent
- 40: laser element
- 45: insulation sheet
- 46: opening hole
- 47: continuous passage
- 50: adhesive
- L: laser beam
- S: application space

## Claims

1. A laser module including a laser element that emits a laser beam, the laser module comprising:
a first block that is electrically connected to a positive electrode of the laser element;
an insulation sheet that is placed on the first block; and
a second block that is placed above the first block with the insulation sheet interposed between the first block and the second block, the second block being electrically connected to a negative electrode of the laser element,
wherein the first block includes a facing surface facing the second block serving as a first adherend surface, and the second block includes a facing surface facing the first block serving as a second adherend surface, and
the first block and the second block are bonded with an adhesive applied to the first adherend surface and the second adherend surface.

2. The laser module according to Claim 1, wherein
the insulation sheet includes an opening hole penetrating in a thickness direction, and
the adhesive is applied to an application space surrounded by the first adherend surface of the first block, the second adherend surface of the second block, and a periphery of the opening hole of the insulation sheet.

3. The laser module according to Claim 2, wherein the insulation sheet includes a continuous passage connected to an inside and an outside of the application space.

4. The laser module according to Claim 2, wherein at least one of the first block and the second block includes a vent connected to an inside and an outside of the application space.

5. The laser module according to any one of Claims 1 to 4, wherein at least one of the first adherend surface and the second adherend surface includes a recess.

6. The laser module according to any one of Claims 2 to 4, wherein at least one of the first block and the second block includes an vent hole connected to the application space.

7. The laser module according to any one of Claims 1 to 6, wherein the adhesive has higher thermal conductivity than the insulation sheet.
